# EUROPEAN PATENT APPLICATION

(11) **EP 4 815 220 A1**
(43) Date of publication of application: **30.09.2026**
(21) Application number: 24910711.1
(22) Date of filing: 11.12.2024
(51) Int. Cl.: H01S 5/02355

(54) **PHOTOELECTRIC PACKAGING STRUCTURE AND MANUFACTURING METHOD THEREFOR**

(30) Priority: 29.12.2023 CN 202311864457
(71) Applicant: SJ Semiconductor (Jiangyin) Corporation, Jiangyin City Wuxi, Jiangsu 214437 (CN)
(72) Inventor: CHEN, Yenheng, Wuxi, Jiangsu 214437 (CN); LIN, Chengchung, Wuxi, Jiangsu 214437 (CN)
(74) Representative: Canzler & Bergmeier Patentanwälte Partnerschaft mbB
(86) International application number: PCT/CN2024/138326
(87) International publication number: WO 2025/139780

(57) **Abstract**

The present invention provides a photoelectric packaging structure and a manufacturing method therefor, comprising the following steps: providing an integrated electric chip comprising a plurality of electric chip units, and forming a plurality of reflective chip structures on the basis thereof, each reflective chip structure being an electric chip unit having a reflective portion attached to at least one side wall, and a reflective surface of the reflective portion being at a preset angle with a bottom surface of the electric chip unit; providing a substrate, and electrically connecting the reflective chip structures to the substrate; providing at least one semiconductor edge-emitting laser spaced a first preset distance from the reflective chip structures, and electrically connecting same to the substrate, the reflective surfaces being located on an optical path of light emitted by the semiconductor edge-emitting laser; forming a protective casing above the substrate, the protective casing being spaced a second preset distance from a side of the semiconductor edge-emitting laser away from the reflective chip structures, and a light emission opening being provided thereabove; and forming a light transmission component above the protective casing and covering the light emission opening. The photoelectric package structure and the manufacturing method therefor of the present invention reduce the package size of the photoelectric package structure.

## Description

### FIELD OF TECHNOLOGY

The present disclosure relates to the technical field of semiconductor manufacturing, and more particularly, to an optoelectronic package structure and a method for manufacturing the same.

### BACKGROUND

An optoelectronic package structure refers to a co-packaged structure formed by integrating an integrated electrical chip and a laser on a same substrate, thereby forming a chip-and-module co-package, which features high integration, support for high data rates, and low cost.

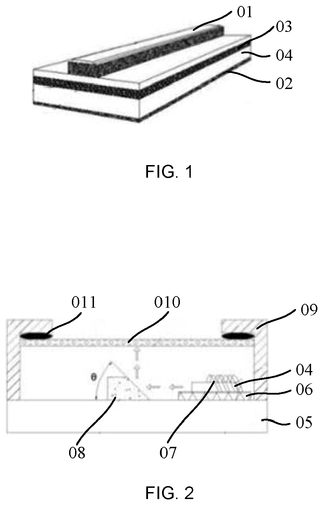

At present, a semiconductor edge-emitting laser (Edge-Emitting Laser, EEL), an important component in the optoelectronic industry, has a structure as shown in FIG. 1, comprising a P-type layer 01, an N-type layer 02, an active layer 03, and a semiconductor laser chip 04. Such a semiconductor edge-emitting laser typically adopts a conventional packaging process. As shown in FIG. 2, a packaging structure of the semiconductor edge-emitting laser comprises a semiconductor laser chip 04, a substrate 05, a conductive base 06, a bonding wire 07, a prism 08, a copper cup 09, a light-transmissive component 010, and an adhesive 011. In such a structure, the conductive base is disposed on a surface of the substrate, and the semiconductor laser chip is disposed on a surface of the conductive base facing away from the substrate, such that the semiconductor laser chip is parallel to the conductive base. This ensures that the bonding wire connecting the semiconductor laser chip 04 and the conductive base 06 has a planar configuration, thereby improving bonding reliability and manufacturing efficiency. Light emitted from the semiconductor laser chip is reflected outward from the laser edge by a reflective component (not shown).

In addition, due to the relatively large size of the integrated electrical chip, when the semiconductor edge-emitting laser and the integrated electrical chip are packaged together, an additional reflective component is required at outside the laser to redirect the light emitted by the semiconductor edge-emitting laser, thereby making it difficult to meet the requirements of high-density integrated packaging.

Accordingly, there is an urgent need for a method for manufacturing an optoelectronic package structure that can integrate a semiconductor laser chip and an electrical chip while achieving a reduced package size.

### SUMMARY

The present disclosure provides an optoelectronic package structure and a method for manufacturing the same.

The method for manufacturing the optoelectronic package structure comprises:
providing an integrated electrical chip comprising a plurality of electrical chip units, and forming a plurality of reflective chip structures on the integrated electrical chip, wherein each one of the plurality of electrical chip units is provided with one the plurality of the reflective chip structures, wherein each one of the plurality of reflective chip structures comprises a reflective portion which is attached to at least one sidewall thereof, and wherein a reflective surface of the reflective portion forms a predetermined angle with a bottom surface of the respective one of the plurality of electrical chip units;
providing a substrate, and electrically connecting the plurality of reflective chip structures to the substrate;
providing a semiconductor edge-emitting laser, and electrically connecting the semiconductor edge-emitting laser to the substrate; the semiconductor edge-emitting laser is placed adjacent to but spaced apart from one of the plurality of reflective chip structures by a first predetermined distance, and the reflective surface of the reflective portion is located on an optical path of light emitted by the semiconductor edge-emitting laser;
forming a protective housing above the substrate, wherein the protective housing surrounds the semiconductor edge-emitting laser and said one of the plurality of reflective chip structures, wherein the protective housing is spaced apart from a side of the semiconductor edge-emitting laser away from said one of the plurality of reflective chip structures by a second predetermined distance, and wherein a light exit port is defined at an upper portion of the protective housing; and
forming a light-transmissive component above the protective housing, the light-transmissive component mounting on the light exit port.

Optionally, forming the plurality of reflective chip structures comprises: dicing the integrated electrical chip to obtain the plurality of electrical chip units, wherein each one of the plurality of electrical chip units has an inclined sidewall with a single slope, and wherein forming the reflective portion on the inclined sidewall of said one of the plurality of electrical chip units enables the inclined sidewall of said electrical chip unit serve as the reflective surface.

Optionally, forming the plurality of reflective chip structures comprises: dicing the integrated electrical chip to obtain the plurality of electrical chip units, wherein each of the plurality of electrical chip units comprises a chamfered sidewall, and forming the reflective portion on at least one sidewall of one of the plurality of the electrical chip units, wherein the chamfered sidewall comprises an inclined surface on top of a vertical surface, and wherein the inclined surface with the reflective portion serves as the reflective surface.

Optionally, forming the plurality of the reflective chip structures comprises: forming a plurality of grooves in the integrated electrical chip, forming a filling layer in each of the plurality of grooves, dicing integrated electrical chip and the filling layer to obtain the plurality of electrical chip units, and forming the reflective portion on at least one sidewall of one the plurality of electrical chip units to obtain an appropriate reflective chip structure, where a post dice sidewall of the filling layer with a reflective potion serves as the reflective surface.

Optionally, forming the plurality of reflective chip structures comprises: dicing the integrated electrical chip to obtain the plurality of electrical chip units, forming a bonding layer on an upper surface of each of the plurality of the electrical chip units, and adhering the reflective portion above said electrical chip unit to obtain an appropriate reflective chip structure, where a sidewall of the reflective portion serves as the reflective surface.

Optionally, the reflective portion of each of the plurality of reflective chip structures is formed by sputtering, coating, or molding.

Optionally, the reflective portion of each of the plurality of reflective chip structures comprises a highly reflective metal layer and a composite layer.

Optionally, the semiconductor edge-emitting laser comprises a laser diode and a semiconductor laser chip.

Optionally, the substrate is provided with a plurality of pads, each of the plurality of reflective chip structures is electrically connected to the substrate through one of the plurality of pads, and the semiconductor edge-emitting laser is electrically connected to the substrate through of the plurality of pads.

Optionally, after the semiconductor edge-emitting laser is electrically connected to the substrate and before the protective housing is formed, the method further comprises forming an underfill below the semiconductor edge-emitting laser and each one of the plurality of reflective chip structures.

Optionally, the protective housing is provided with a protruding portion, and the light-transmissive component is disposed above the protective housing via the protruding portion.

The present disclosure further provides an optoelectronic package structure, where the optoelectronic package structure is manufactured by the method according to any one of the above.

As described above, the optoelectronic package structure and the method for manufacturing the same provided by the present disclosure have the following beneficial effects. In the present disclosure, each reflective chip structure is formed by using an electrical chip unit having a reflective portion attached to at least one sidewall thereof. The reflective surface of the reflective portion forms a predetermined angle with a bottom surface of the electrical chip unit and is located on an optical path of light emitted by the semiconductor edge-emitting laser. Accordingly, light emitted by the semiconductor edge-emitting laser is directly reflected by the reflective portion and exits through the light-transmissive component without requiring an additional reflecting component. Therefore, the optoelectronic package structure of the present disclosure not only enables integrated packaging of the integrated electrical chip and the semiconductor laser chip, but also reduces the overall package size. In addition, the light-transmissive component is disposed above the protective housing via the protruding portion provided on the protective housing, thereby preventing the light-transmissive component from slipping off.

### BRIEF DESCRIPTION OF THE DRAWINGS

FIG. 1 is a schematic structural diagram of a conventional edge-emitting semiconductor laser.
FIG. 2 is a schematic packaging structural diagram of a conventional semiconductor edge-emitting laser.
FIG. 3 is a schematic flowchart of a method for manufacturing an optoelectronic package structure according to the present disclosure.
FIG. 4 is a schematic structural diagram of an integrated electrical chip according to the present disclosure.
FIG. 5 is a schematic structural diagram of the integrated electrical chip arranged on a dicing tape according to the present disclosure.
FIG. 6 is a schematic structural diagram after dicing the integrated electrical chip according to Embodiment 1 of the present disclosure.
FIG. 7 is a schematic structural diagram after forming a reflective portion on the integrated electrical chip according to Embodiment 1 of the present disclosure.
FIG. 8 is a schematic structural diagram after electrically connecting a reflective chip structure to a substrate according to Embodiment 1 of the present disclosure.
FIG. 9 is a schematic structural diagram after electrically connecting a semiconductor edge-emitting laser to the substrate according to Embodiment 1 of the present disclosure.
FIG. 10 is a schematic structural diagram after forming an underfill according to Embodiment 1 of the present disclosure.
FIG. 11 is a schematic structural diagram after forming a protective housing according to Embodiment 1 of the present disclosure.
FIG. 12 is a schematic structural diagram after forming a light-transmissive component according to Embodiment 1 of the present disclosure.
FIG. 13 is a schematic structural diagram after dicing the integrated electrical chip according to Embodiment 2 of the present disclosure.
FIG. 14 is a schematic structural diagram after forming the reflective portion according to Embodiment 2 of the present disclosure.
FIG. 15 is a schematic structural diagram after electrically connecting the reflective chip structures to the substrate according to Embodiment 2 of the present disclosure.
FIG. 16 is a schematic structural diagram after forming the underfill according to Embodiment 2 of the present disclosure.
FIG. 17 is a schematic structural diagram after forming the protective housing according to Embodiment 2 of the present disclosure.
FIG. 18 is a schematic structural diagram after forming the light-transmissive component according to Embodiment 2 of the present disclosure.
FIG. 19 is a schematic structural diagram after forming grooves according to Embodiment 3 of the present disclosure.
FIG. 20 is a schematic structural diagram after forming a filling layer according to Embodiment 3 of the present disclosure.
FIG. 21 is a schematic structural diagram after dicing the filling layer according to Embodiment 3 of the present disclosure.
FIG. 22 is a schematic structural diagram after forming the reflective portion according to Embodiment 3 of the present disclosure.
FIG. 23 is a schematic structural diagram after forming the underfill according to Embodiment 3 of the present disclosure.
FIG. 24 is a schematic structural diagram after forming the protective housing according to Embodiment 3 of the present disclosure.
FIG. 25 is a schematic structural diagram after forming the light-transmissive component according to Embodiment 3 of the present disclosure.
FIG. 26 is a schematic structural diagram after electrically connecting the semiconductor edge-emitting laser to the substrate according to Embodiment 4 of the present disclosure.
FIG. 27 is a schematic structural diagram after forming the underfill according to Embodiment 4 of the present disclosure.
FIG. 28 is a schematic structural diagram after forming the light-transmissive component according to Embodiment 4 of the present disclosure.
FIG. 29 is a schematic top diagram of a part of the optoelectronic package structure according to the present disclosure.

Reference numerals
- 01: P-type layer
- 02: N-type layer
- 03: Active layer
- 04: Semiconductor laser chip
- 05: Substrate
- 06: Conductive base
- 07: Bonding wire
- 08: Prism
- 09: Copper cup
- 10: Light-transmissive component (prior-art)
- 11: Adhesive (prior-art)
- 1: Integrated electrical chip
- 11: Electrical chip unit
- 12: First solder ball
- 13: Groove
- 14: Filling layer
- 2: Reflective chip structures
- 21: Reflective portion
- 3: Dicing tape
- 31: Fixing block
- 4: Dicing blade
- 5: Substrate
- 51: Pad
- 52: Solder
- 6: Semiconductor edge-emitting laser
- 61: Laser diode
- 62: Semiconductor laser chip
- 63: Second solder ball
- 7: Protective housing
- 71: Solder block
- 72: Protruding portion
- 73: Light exit port
- 8: Underfill
- 9: Light-transmissive component
- 91: Adhesive
- 10: Bonding layer

### DETAILED DESCRIPTION

The embodiments of the present disclosure are described below with specific examples, and those skilled in the art can easily understand other advantages and effects of the present disclosure from the content disclosed in the present description.

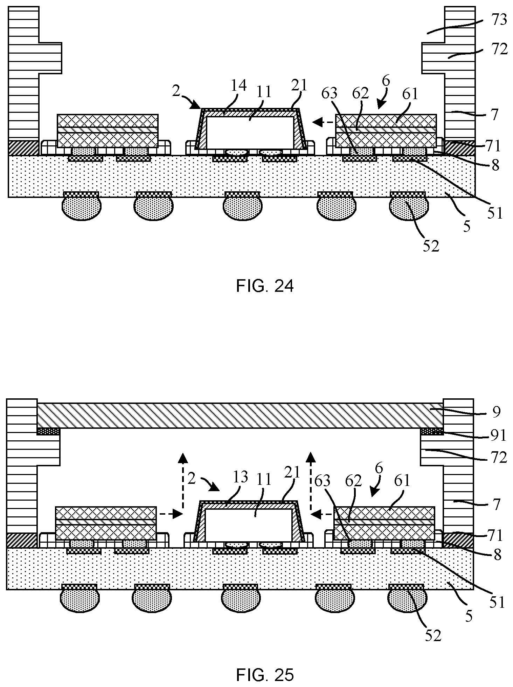

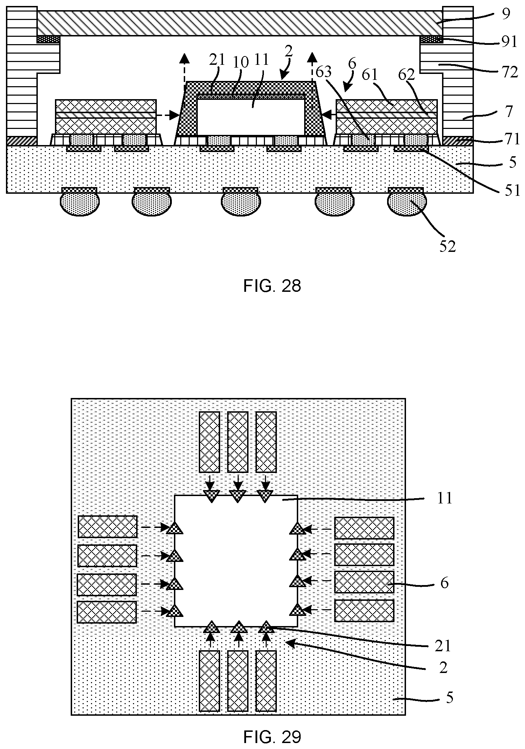

Please refer to FIGs. 1 to 29. It should be noted that the structures, proportions, sizes, and the like illustrated in the drawings attached to this specification are merely provided to facilitate understanding of the content disclosed in the specification by those skilled in the art, and are not intended to limit the applicable scope of the present disclosure. Therefore, they have no substantive technical significance. Any modification of structure, change in proportional relationship, or adjustment in size shall still fall within the scope of the technical content disclosed in the present disclosure, provided that the functions and objectives of the present disclosure are not affected. Meanwhile, terms such as "upper," "lower," "left," "right," "middle," and "one" used in this specification are merely for clarity of description and are not intended to limit the scope of the present disclosure. Any change or adjustment of the relative relationships thereof shall, in the absence of substantial changes to the technical content, also be considered to fall within the scope of the present disclosure.

### Embodiment 1

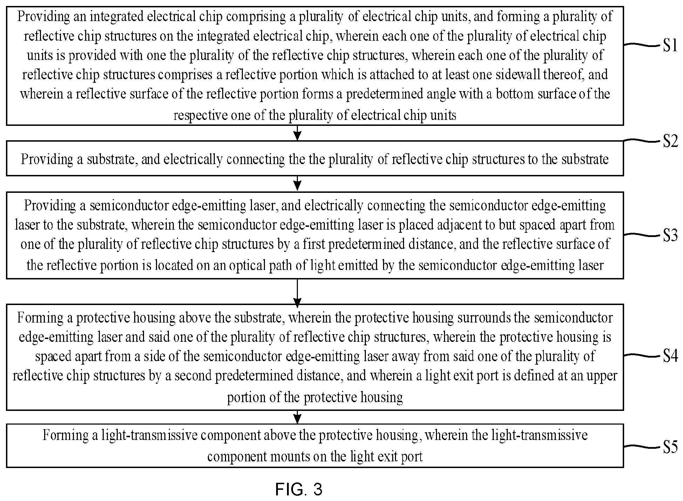

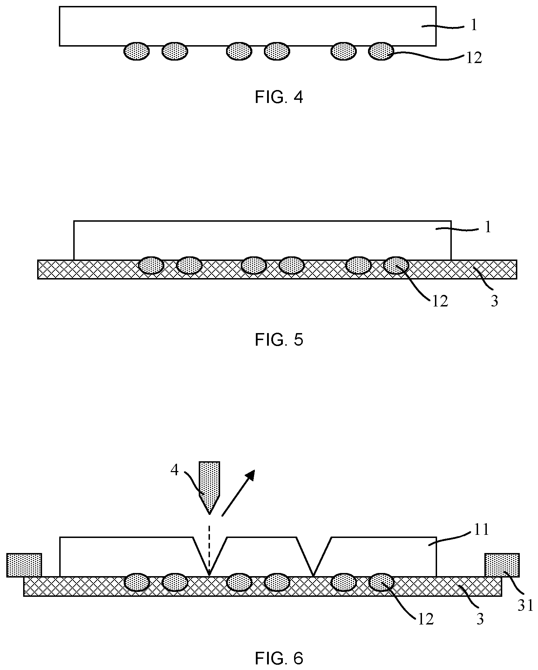

The present disclosure provides a method for manufacturing an optoelectronic package structure. FIG. 3 is a schematic flowchart illustrating the manufacturing method of an optoelectronic package structure, comprising the following steps:
Step 1: providing an integrated electrical chip comprising a plurality of electrical chip units, forming a plurality of reflective chip structures based on the integrated electrical chip, where each of the reflective chip structures comprises a respective electrical chip unit having a reflective portion attached to at least one sidewall thereof, and a reflective surface of the reflective portion forms a predetermined angle with a bottom surface of the respective electrical chip unit;
Step 2: providing a substrate, and electrically connecting the reflective chip structures to the substrate;
Step 3: providing at least one semiconductor edge-emitting laser, and electrically connecting the semiconductor edge-emitting laser to the substrate, where the semiconductor edge-emitting laser is next to but spaced apart from the reflective chip structures by a first predetermined distance, and the reflective surface of the reflective portion is located on an optical path of the light emitted by the semiconductor edge-emitting laser;
Step 4: forming a protective housing above the substrate, the protective housing surrounding the semiconductor edge-emitting laser and the reflective chip structures, where the protective housing is spaced apart from a side of the semiconductor edge-emitting laser away from the reflective chip structures by a second predetermined distance, and a light exit port is defined at an upper portion of the protective housing;
Step 5: forming a light-transmissive component above the protective housing, the light-transmissive component mounted on the light exit port.
Specifically, referring to FIGs. 4 to 7, step 1 is performed: an integrated electrical chip 1 comprising a plurality of electrical chip units 11 is provided, a plurality of reflective chip structures 2 are formed based on the integrated electrical chip 1, each of the reflective chip structures 2 comprises a respective electrical chip unit 11 having a reflective portion 21 attached to at least one sidewall thereof, and a reflective surface of the reflective portion 21 forms a predetermined angle with a bottom surface of the respective electrical chip unit 11.

Specifically, the size and material of the integrated electrical chip 1 may be selected according to actual conditions without limiting the performance of the optoelectronic package structure.

Specifically, FIG. 4 is a schematic structural diagram of the integrated electrical chip 1, and first solder balls 12 are further disposed below the electrical chip unit 11.

Specifically, the size and material of the first solder balls 12 may be selected according to actual conditions without limiting the performance of the optoelectronic package structure.

As an example, forming the reflective chip structures 2 includes: dicing the integrated electrical chip 1 to obtain an electrical chip unit 11 having a single inclined sidewall, and forming the reflective portion 21 on at least one sidewall of the electrical chip unit 11 to obtain an appropriate reflective chip structure 2, where the single inclined sidewall of the electrical chip unit 11 serves as the reflective surface.

Specifically, FIG. 5 and FIG. 6 are respectively a schematic structural diagram of the integrated electrical chip 1 arranged on a dicing tape 3 and a schematic structural diagram after dicing the integrated electrical chip 1. Dicing the integrated electrical chip 1 includes: placing the integrated electrical chip 1 on the dicing tape 3, and performing a full cutting on the integrated electrical chip 1 to obtain the electrical chip unit 11 having a single inclined sidewall.

Specifically, the size and material of the dicing tape 3 may be selected according to actual conditions without limiting the performance of the optoelectronic package structure.

Specifically, by placing the integrated electrical chip 1 on the dicing tape 3 for cutting, damage to the integrated electrical chip 1 caused by stress during the dicing process can be avoided

Specifically, fixing blocks 31 are further disposed on two sides of the dicing tape 3 to maintain the dicing tape 3 in a stretched state and to define a dicing region on the integrated electrical chip 1.

Specifically, the method for dicing the integrated electrical chip 1 includes at least one of dicing blade cutting and laser cutting or other suitable dicing methods.

Specifically, when blade dicing is employed to cut the integrated electrical chip 1, a dicing blade 4 may be used to perform a single-blade full cut on the integrated electrical chip 1, thereby obtaining an electrical chip unit 11 having a single inclined sidewall.

Specifically, the predetermined angle between the sidewall of the electrical chip unit 11 and the bottom surface thereof is in a range of 0° to 90°.

As an example, the reflective portion 21 includes a highly reflective metal layer and a composite layer thereof or other suitable materials.

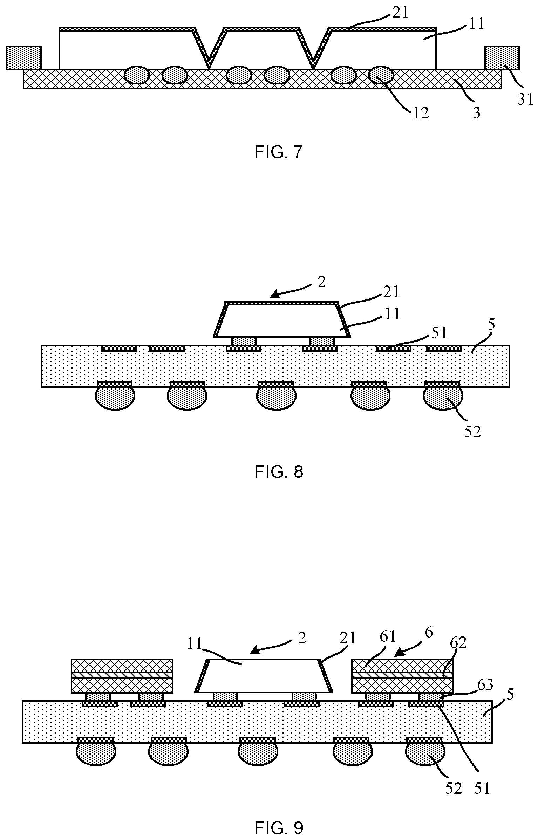

As an example, FIG. 7 is a schematic structural diagram after forming the reflective portion 21, and the reflective portion 21 is formed by sputtering, coating or other suitable methods.

Specifically, after the reflective portion 21 is formed, the dicing tape 3 is removed to obtain an appropriate reflective chip structure 2.

Specifically, referring to FIG. 8, step 2 is performed: a substrate 5 is provided, and the reflective chip structure 2 is electrically connected to the substrate 5.

Specifically, the size and material of the substrate 5 may be selected according to actual conditions without limiting the performance of the optoelectronic package structure.

As an example, FIG. 8 is a schematic structural diagram after electrically connecting the reflective chip structure 2 to the substrate 5, the substrate 5 is provided with a plurality of pads 51, and the reflective chip structure 2 is electrically connected to the substrate 5 through the pads 51.

Specifically, the reflective chip structure 2 is electrically connected to the pads 51 in the substrate 5 through the first solder balls 12.

Specifically, solders 52 electrically connected to the pad 51 are further arranged below the substrate 5.

Specifically, referring to FIGs. 9 to 10, step 3 is performed: at least one semiconductor edge-emitting laser 6 is provided, the semiconductor edge-emitting laser 6 is electrically connected to the substrate 5, the semiconductor edge-emitting laser 6 is spaced apart from the reflective chip structure 2 by a first predetermined distance, and the reflective surface of the reflective portion 21 is located on an optical path of light emitted by the semiconductor edge-emitting laser 6.

As an example, FIG. 9 is a schematic structural diagram after electrically connecting the semiconductor edge-emitting laser 6 to the substrate 5, and the semiconductor edge-emitting laser 6 includes a laser diode 61 and a semiconductor laser chip 62.

Specifically, the laser diode 61 and the semiconductor laser chip 62 are arranged in parallel.

Specifically, the light emitted by the semiconductor edge-emitting laser 6 is emitted by the semiconductor laser chip 62 and emitted from a side surface of the semiconductor edge-emitting laser 6.

Specifically, the semiconductor edge-emitting laser 6 is spaced apart from the reflective chip structure 2 by a first predetermined distance.

Specifically, the semiconductor edge-emitting laser 6 and the reflective chip structure 2 are arranged correspondingly in a horizontal direction, so as to ensure that light emitted by the semiconductor edge-emitting laser 6 irradiates the reflective portion 21 on the sidewall of the reflective chip structure 2.

Specifically, the spacing distance between the semiconductor edge-emitting laser 6 and the reflective chip structure 2 and the number of the semiconductor edge-emitting lasers 6 may be selected according to actual conditions without limiting the performance of the optoelectronic package structure.

As an example, the substrate 5 is provided with a plurality of pads 51, and the semiconductor edge-emitting laser 6 is electrically connected to the substrate 5 through the pads 51.

Specifically, the semiconductor edge-emitting laser 6 is electrically connected to the pads 51 in the substrate 5 through second solder balls 63.

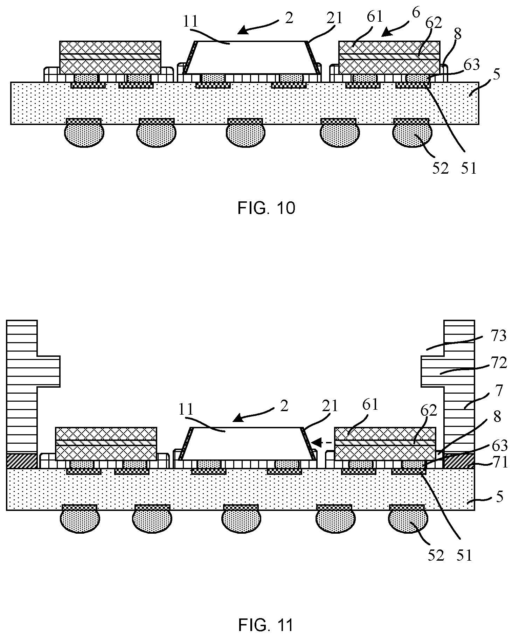

As an example, FIG. 10 is a schematic structural diagram after forming an underfill 8. After the semiconductor edge-emitting laser 6 is electrically connected to the substrate and before the protective housing 7 is formed, the method further includes forming the underfill 8 below the semiconductor edge-emitting laser 6 and the reflective chip structure 2.

Specifically, the underfill 8 serves to protect the semiconductor edge-emitting laser 6 and the reflective chip structure 2.

Specifically, the size and material of the underfill 8 may be selected according to actual conditions without limiting the performance of the optoelectronic package structure.

Specifically, referring to FIGs. 11 to 12, steps 4 to 5 are performed: a protective housing 7 surrounding the semiconductor edge-emitting laser 6 and the reflective chip structure 2 are formed above the substrate 5, the protective housing 7 is spaced apart from a side of the semiconductor edge-emitting laser 6 away from the reflective chip structure 2 by a second predetermined distance, and a light exit port 73 is defined at an upper portion of the protective housing 7; a light-transmissive component 9 covering the light exit port 73 is formed above the protective housing 7.

Specifically, FIG. 11 is a schematic structural diagram after forming the protective housing 7, and the protective housing 7 is mounted above the substrate 5 through the solder block 71.

Specifically, the size, shape and material of the protective housing 7 may be selected according to actual conditions without limiting the performance of the optoelectronic package structure.

As an example, the protective housing 7 is provided with a protruding portion 72, and the light-transmissive component 9 is disposed above the protective housing 7 via the protruding portion 72.

Specifically, the light-transmissive component 9 is disposed above the protective housing 7 via the protruding portion 72, thereby preventing the light-transmissive component 9 from slipping off.

Specifically, the protective housing 7 is spaced apart from the side of the semiconductor edge-emitting laser 6 away from the reflective chip structure 2 by a second predetermined distance, so as to protect the semiconductor edge-emitting laser 6 and the reflective chip structure 2 and ensure the heat dissipation performance of the optoelectronic package structure.

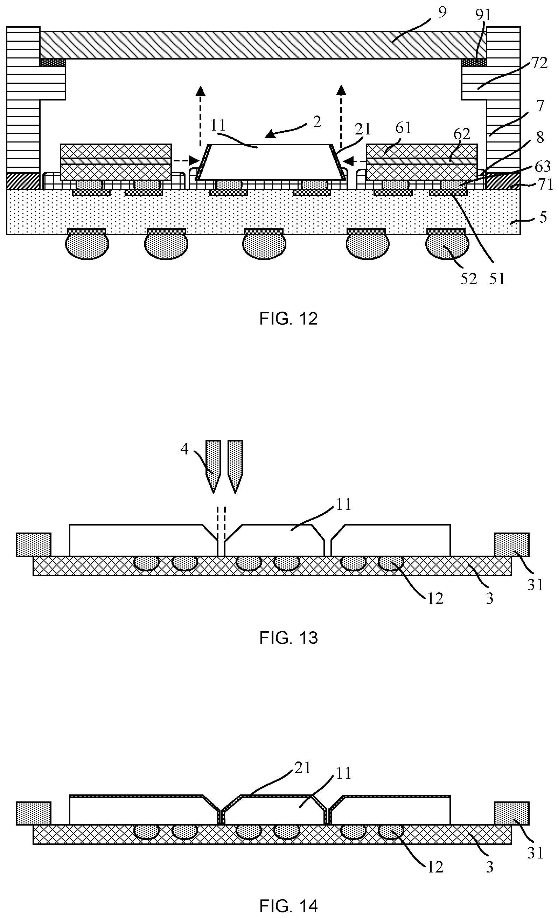

As an example, FIG. 12 is a schematic structural diagram after forming the light-transmissive component 9, and the light-transmissive component 9 is bonded above the protective housing through an adhesive 91.

Specifically, the light emitted by the semiconductor edge-emitting laser 6 is reflected by the reflective chip structure 2 and emitted from the light-transmissive component 9.

Specifically, the integrated electrical chip 1 is diced to obtain an electrical chip unit 11 having a single inclined sidewall, the reflective portion 21 is formed on at least one sidewall of the electrical chip unit 11 to obtain the reflective chip structure 2, where the single inclined sidewall of the electrical chip unit 11 serves as the reflective surface, and the light emitted by the semiconductor edge-emitting laser 6 is directly reflected by the reflective portion 21 located on the sidewall of the electrical chip unit 11 and exits through the light-transmissive component 9 without requiring an additional reflecting component, thereby not only realizing integrated packaging of the integrated electrical chip 1 and the semiconductor laser 6, but also reducing the package size of the optoelectronic package structure.

In the method according to Embodiment 1, the integrated electrical chip 1 is diced to obtain an electrical chip unit 11 having a single inclined sidewall, the reflective portion 21 is formed on at least one sidewall of the electrical chip unit 11 to obtain the reflective chip structure 2, where the single inclined sidewall of the electrical chip unit 11 serves as the reflective surface, and the light emitted by the semiconductor edge-emitting laser 6 is directly reflected by the reflective portion 21 located on the sidewall of the electrical chip unit 11 and exits through the light-transmissive component 9 without requiring an additional reflecting component, thereby not only realizing integrated packaging of the integrated electrical chip 1 and the semiconductor laser 6, but also reducing the package size of the optoelectronic package structure.

### Embodiment 2

Embodiment 2 provides a second method for manufacturing an optoelectronic package structure. Referring to FIGs. 13 to 18, the method according to Embodiment 2 is improved from the method according to Embodiment 1. Forming the reflective chip structures 2 (a different reflective chip structure from in Embodiment 1, although sharing the same numeral 2) includes: dicing the integrated electrical chip 1 to obtain an electrical chip unit 11 having a chamfered sidewall, and forming the reflective portion 21(a different reflective portion from in Embodiment 1, although sharing the same numeral 21) on at least one sidewall of the electrical chip unit 11 to obtain an appropriate reflective chip structure 2, where the chamfered sidewall of each of the electrical chip units 11 includes an inclined surface above a vertical surface, and the inclined surface will be made reflective so as to be the reflective surface.

Specifically, the method for dicing the integrated electrical chip 1 includes applying at least one of dicing blade cutting, laser cutting, and other suitable dicing methods.

Specifically, FIG. 13 and FIG. 14 respectively show a further schematic structural diagram after dicing the integrated electrical chip 1 and a further schematic structural diagram after forming the reflective portion 21. When the integrated electrical chip 1 is cut by a dicing blade cutting method, a dicing blade 4 may be used to perform double-blade full cutting on the integrated electrical chip to obtain a single electrical chip unit 11 having a chamfered sidewall, where the inclined surface in the inclined surface is made to be reflective.

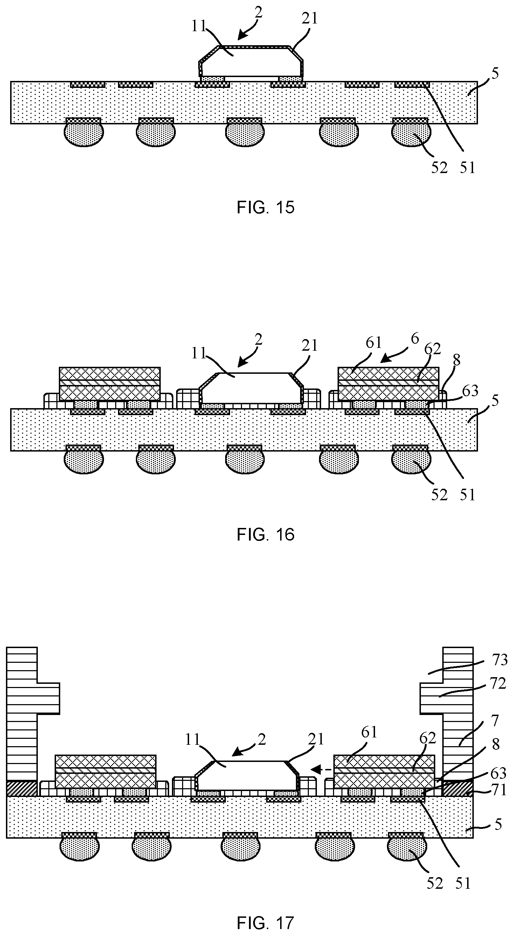

Specifically, FIG. 15 to FIG. 18 respectively show a second schematic structural diagram after electrically connecting the reflective chip structure 2 to the substrate 5, a second schematic structural diagram after forming the underfill 8, a second schematic structural diagram after forming the protective housing 7, and a second schematic structural diagram after forming the light-transmissive component 9. The electrical connection between the reflective chip structure 2 and the substrate 5, the electrical connection between the semiconductor edge-emitting laser 6 and the substrate 5, and subsequent formation of the underfill 8, the protective housing 7 and the light-transmissive component 9 may refer to embodiment 1, and details are not repeated herein.

Specifically, the integrated electrical chip 1 is diced to obtain the electrical chip unit 11 having the chamfered sidewall, the reflective portion 21 is formed on at least one sidewall of the electrical chip unit 11 to obtain the reflective chip structure 2, where the inclined surface in the chamfered sidewall of the electrical chip unit 11 has the reflective portion so as to serve as the reflective surface, and the light emitted by the semiconductor edge-emitting laser 6 is directly reflected by the reflective portion 21 located on the sidewall of the electrical chip unit 11 and exits through the light-transmissive component 9 without requiring an additional reflecting component, thereby not only realizing integrated packaging of the integrated electrical chip 1 and the semiconductor laser 6, but also reducing the package size of the optoelectronic package structure.

In the method according to Embodiment 2, the integrated electrical chip 1 is diced to obtain an electrical chip unit 11 having a chamfered sidewall, the reflective portion 21 is formed on at least one sidewall of the electrical chip unit 11 to obtain the reflective chip structure 2, where the inclined surface in the chamfered sidewall of the electrical chip unit 11 has the reflective portion so as to serve as the reflective surface, and the light emitted by the semiconductor edge-emitting laser 6 is directly reflected by the reflective portion 21 located on the sidewall of the electrical chip unit 11 and exits through the light-transmissive component 9 without requiring an additional reflecting component, thereby not only realizing integrated packaging of the integrated electrical chip 1 and the semiconductor laser 6, but also reducing the package size of the optoelectronic package structure.

### Embodiment 3

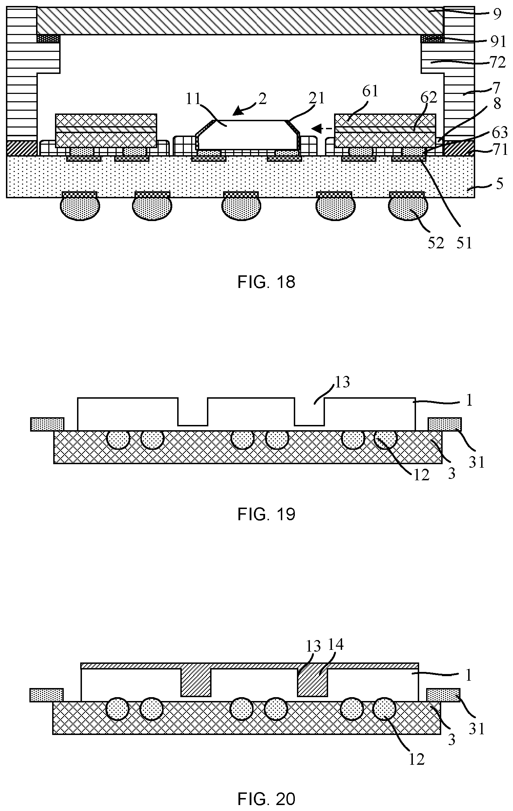

Embodiment 3 provides a third method for manufacturing an optoelectronic package structure. Referring to FIGs. 19 to 25, the method according to Embodiment 3 is improved from the method according to Embodiment 1. Forming the reflective chip structures 2 (a different reflective chip structure from in Embodiments 1 and 2, although sharing the same numeral 2) includes: forming a plurality of grooves 13 in the integrated electrical chip 1, forming a filling layer 14 in each of the grooves 13, dicing the filling layer 14 to obtain an electrical chip unit 11, and forming the reflective portion 21 (a different reflective portion 21 from in Embodiments 1 and 2, although sharing the same numeral 21) on at least one sidewall of the electrical chip unit 11 to obtain an appropriate reflective chip structure 2, where a post dice sidewall of the inclined filling layer 14 with the reflective portion 21 on its surface serves as the reflective surface.

Specifically, FIG. 19 is a schematic structural diagram after forming the grooves 13. A method for forming the grooves 13 includes half-cutting or other suitable methods.

Specifically, the depth of the groove 13 may be selected according to actual conditions without limiting the performance of the optoelectronic package structure. The depth herein refers to a vertical distance from the top of the groove 13 to the bottom of the groove 13.

Specifically, the material of the filling layer 14 includes epoxy resin or other suitable materials.

Specifically, FIG. 20 is a schematic structural diagram after forming the filling layer 14. A method for forming the filling layer 14 includes chemical vapor deposition, physical vapor deposition or other suitable methods.

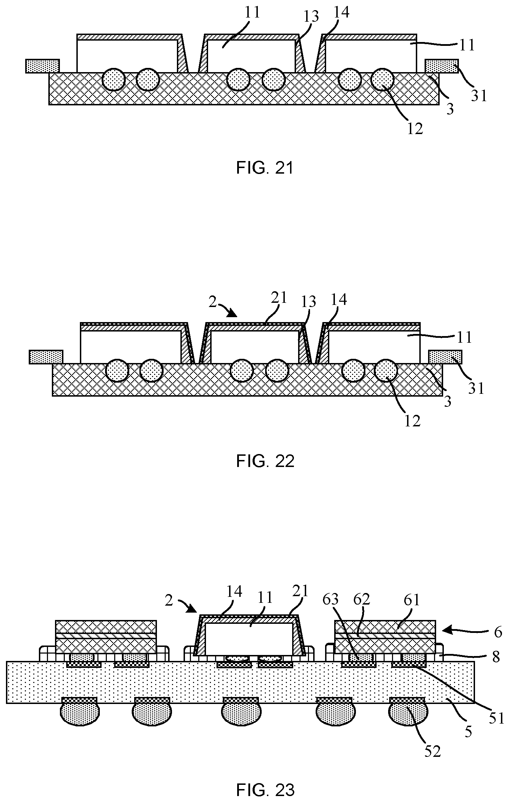

Specifically, FIG. 21 is a schematic structural diagram after dicing the inclined filling layer 14. A method for dicing the filling layer 14 includes cutting, patterning or other suitable methods.

As an example, FIG. 22 is a third schematic structural diagram after forming the reflective portion 21, and the reflective portion 21 is formed by sputtering, coating or other suitable methods.

Specifically, the resultant reflective portion 21 covers an exposed surface of the filling layer 14.

Specifically, FIG. 23 to FIG. 25 respectively show a third schematic structural diagram after forming the underfill 8, a third schematic structural diagram after forming the protective housing 7, and a third schematic structural diagram after forming the light-transmissive component 9. Formation of the reflective chip structure 2, electrical connection between the semiconductor edge-emitting laser 6 and the substrate 5, and subsequent formation of the underfill 8, the protective housing 7 and the light-transmissive component 9 may refer to Embodiment 1, and details are not repeated herein.

Specifically, the plurality of grooves 13 are formed in the integrated electrical chip 1, the filling layer 14 is formed in each of the grooves 13, the filling layer 14 is diced to obtain an electrical chip unit 11, the reflective portion 21 is formed on at least one sidewall of the electrical chip unit 11 to obtain the reflective chip structure 2, where the post dice sidewall of the filling layer 14 serves as the reflective surface, and the filling layer 14 is formed to avoid a risk of chipping of the integrated electrical chip 1 during dicing. The light emitted by the semiconductor edge-emitting laser 6 is directly reflected by the reflective portion 21 and exits through the light-transmissive component 9 without requiring an additional reflecting component, thereby not only realizing integrated packaging of the integrated electrical chip 1 and the semiconductor laser 6, but also reducing the package size of the optoelectronic package structure.

In the method according to Embodiment 3, the plurality of grooves 13 are formed in the integrated electrical chip 1, the filling layer 14 is formed in each of the grooves 13, the filling layer 14 is diced to obtain an electrical chip unit 11, the reflective portion 21 is formed on at least one sidewall of the electrical chip unit 11 to obtain the reflective chip structure 2, where the post dice sidewall of the filling layer 14 serves as the reflective surface, and the filling layer 14 is formed to avoid a risk of chipping of the integrated electrical chip 1 during dicing. The light emitted by the semiconductor edge-emitting laser 6 is directly reflected by the reflective portion 21 and exits through the light-transmissive component 9 without requiring an additional reflecting component, thereby not only realizing integrated packaging of the integrated electrical chip 1 and the semiconductor laser 6, but also reducing the package size of the optoelectronic package structure.

### Embodiment 4

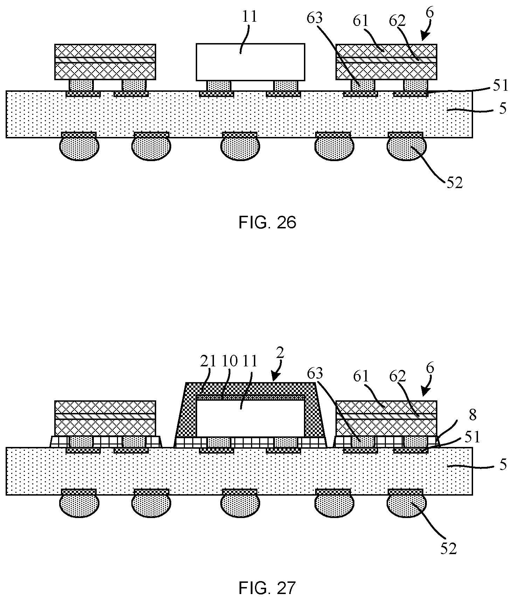

Embodiment 4 provides a fourth method for manufacturing an optoelectronic package structure. Referring to FIGs. 26 to 28, the method according to Embodiment 4 is improved on the basis of the method according to Embodiment 1. Forming the reflective chip structures 2 (a different reflective chip structure from in Embodiments 1, 2, and 3, although sharing the same numeral 2) includes: dicing the integrated electrical chip 1 to obtain an electrical chip unit 11, forming a bonding layer 10 on an upper surface of the electrical chip unit 11, and adhering the reflective portion 21 (a different reflective portion 21 from in Embodiments 1, 2, and 3, although sharing the same numeral 2) above the electrical chip unit 11 to obtain the reflective chip structure 2, where a sidewall of the reflective portion 21 is inclined and serves as the reflective surface.

Specifically, a method for dicing the plurality of electrical chip units 11 in the integrated electrical chip 1 includes laser cutting or other suitable methods.

As an example, FIG. 26 and FIG. 27 respectively show a schematic structural diagram after electrically connecting the semiconductor edge-emitting laser 6 to the substrate 5 and a fourth schematic structural diagram after forming the underfill 8. A method for forming the reflective portion 21 includes mold forming or other suitable methods.

Specifically, the resultant inclined reflective portion 21 is fastened above the electrical chip unit 11.

Specifically, the reflective portion 21 further includes a reflective grating.

Specifically, FIG. 27 is a fourth schematic structural diagram after forming the light-transmissive component 9. Electrical connection between the reflective chip structures 2 and the substrate 5, electrical connection between the semiconductor edge-emitting laser 6 and the substrate 5, and subsequent formation of the underfill 8, the protective housing 7 and the light-transmissive component 9 may refer to Embodiment 1, and details are not repeated herein.

Specifically, the integrated electrical chip 1 is diced, the bonding layer 10 is formed on the upper surface of the electrical chip unit 11, and the reflective portion 21 is adhered above the electrical chip unit 11 to obtain the reflective chip structure 2, broadening a process idea for forming the reflective chip structures, where the sidewall of the reflective portion 21 serves as the reflective surface, and the light emitted by the semiconductor edge-emitting laser 6 is directly reflected by the reflective portion 21 and exits through the light-transmissive component 9 without requiring an additional reflecting component, thereby reducing the package size of the optoelectronic package structure.

In the method according to Embodiment 4, the integrated electrical chip 1 is diced, the bonding layer 10 is formed on the upper surface of the electrical chip unit 11, and the reflective portion 21 is adhered above the electrical chip unit 11 to obtain the reflective chip structure 2, broadening a process idea for forming the reflective chip structure, where the sidewall of the reflective portion 21 forms a predetermined angle with a bottom surface of the reflective portion 21, and the light emitted by the semiconductor edge-emitting laser 6 is directly reflected by the reflective portion 21 and exits through the light-transmissive component 9 without requiring an additional reflecting component, thereby reducing the package size of the optoelectronic package structure.

### Embodiment 5

Embodiment 5 provides an optoelectronic package structure, where the optoelectronic package structure is manufactured by the method according to any one of Embodiments 1 to 4.

Specifically, FIG. 12, FIG. 18, FIG. 25, FIG. 28 and FIG. 29 respectively show a schematic structural diagram after forming the light-transmissive component 9, a second schematic structural diagram after forming the light-transmissive component 9, a third schematic structural diagram after forming the light-transmissive component 9, a fourth schematic structural diagram after forming the light-transmissive component 9, and a schematic top diagram of a part of the optoelectronic package structure. The optoelectronic package structure includes: a substrate 5; a reflective chip structure 2 electrically connected to the substrate 5, where the reflective chip structure 2 includes an electrical chip unit 11 having a reflective portion 21 attached to at least one sidewall thereof, and a reflective surface of the reflective portion 21 forms a predetermined angle with a bottom surface of the respective electrical chip unit 11; a semiconductor edge-emitting laser 6 electrically connected to the substrate 5, where the semiconductor edge-emitting laser 6 surrounds the reflective chip structure 2 and is spaced apart from the reflective chip structure 2 by a first predetermined distance; a protective housing 7 disposed above the substrate 5 and surrounding the semiconductor edge-emitting laser 6 and the reflective chip structure 2, where the protective housing 7 is spaced apart from a side of the semiconductor edge-emitting laser 6 away from the reflective chip structure 2 by a second predetermined distance, and a light exit port 73 is defined at an upper portion of the protective housing 7; and a light-transmissive component 9 disposed above the protective housing 7 and mounted on the light exit port 73.

Specifically, the substrate 5 is provided with a plurality of pads 51, the reflective chip structure 2 is electrically connected to the substrate 5 through the pads 51, and the semiconductor edge-emitting laser 6 is electrically connected to the substrate 5 through the pads 51.

Specifically, the light emitted by the semiconductor edge-emitting laser 6 is by the reflective portion 21 of the reflective chip structure 2 and exits through the light-transmissive component 9.

The optoelectronic package structure according to Embodiment 5 achieves integrated packaging of the integrated electrical chip 1 and the semiconductor laser 6, and the light emitted by the semiconductor edge-emitting laser 6 is directly reflected by the reflective portion 21 and exits through the light-transmissive component 9 without requiring an additional reflecting component, thereby reducing the size of the optoelectronic package structure.

In summary, according to the optoelectronic package structure and the method for manufacturing the same of the present disclosure, the electrical chip unit with the reflective portion attached to at least one sidewall is formed as the reflective chip structure, the reflective surface of the reflective portion forms a predetermined angle with the bottom surface of the electrical chip unit, and the reflective surface of the reflective portion is located on the optical path of the light emitted by the semiconductor edge-emitting laser. The light emitted by the semiconductor edge-emitting laser is directly reflected by the reflective portion and exits through the light-transmissive component without requiring an additional reflecting component. Therefore, the optoelectronic package structure of the present disclosure not only realizes integrated packaging of the integrated electrical chip and the semiconductor laser chip, but also reduces the package size of the optoelectronic package structure. In addition, the light-transmissive component is disposed on the protective housing via the protruding portion on the protective housing, preventing the light-transmissive component from slipping off. Accordingly, the present disclosure effectively overcomes various shortcomings in the prior art and has high industrial utilization value.

The above embodiments are merely illustrative of the principles and effects of the present disclosure and are not intended to limit the present disclosure. Any person skilled in the art may modify or change the above embodiments without departing from the spirit and scope of the present disclosure. Accordingly, all equivalent modifications or changes made by those skilled in the art without departing from the spirit and technical ideas disclosed in the present disclosure shall be covered by the claims of the present disclosure.

## Claims

1. A method for manufacturing an optoelectronic package structure, comprising:
providing an integrated electrical chip comprising a plurality of electrical chip units, and forming a plurality of reflective chip structures on the integrated electrical chip, wherein each one of the plurality of electrical chip units is provided with one the plurality of the reflective chip structures, wherein each one of the plurality of reflective chip structures comprises a reflective portion which is attached to at least one sidewall thereof, and wherein a reflective surface of the reflective portion forms a predetermined angle with a bottom surface of the respective one of the plurality of electrical chip units;
providing a substrate, and electrically connecting the plurality of reflective chip structures to the substrate;
providing a semiconductor edge-emitting laser, and electrically connecting the semiconductor edge-emitting laser to the substrate, wherein the semiconductor edge-emitting laser is placed adjacent to but spaced apart from one of the plurality of reflective chip structures by a first predetermined distance, and the reflective surface of the reflective portion is located on an optical path of light emitted by the semiconductor edge-emitting laser;
forming a protective housing above the substrate, wherein the protective housing surrounds the semiconductor edge-emitting laser and said one of the plurality of reflective chip structures, wherein the protective housing is spaced apart from a side of the semiconductor edge-emitting laser away from said one of the plurality of reflective chip structures by a second predetermined distance, and wherein a light exit port is defined at an upper portion of the protective housing; and
forming a light-transmissive component above the protective housing, wherein the light-transmissive component mounts on the light exit port.

2. The method according to claim 1, wherein forming the plurality of reflective chip structures comprises: dicing the integrated electrical chip to obtain the plurality of electrical chip units, wherein each one of the plurality of electrical chip units has an inclined sidewall with a single slope, and wherein forming the reflective portion on the inclined sidewall of said one of the plurality of electrical chip units enables the inclined sidewall of said electrical chip unit serve as the reflective surface.

3. The method according to claim 1, wherein forming the plurality of reflective chip structures comprises: dicing the integrated electrical chip to obtain the plurality of electrical chip units, wherein each of the plurality of electrical chip units comprises a chamfered sidewall, and forming the reflective portion on at least one sidewall of one of the plurality of the electrical chip units, wherein the chamfered sidewall comprises an inclined surface on top of a vertical surface, and wherein the inclined surface with the reflective portion serves as the reflective surface.

4. The method according to claim 1, wherein forming the plurality of the reflective chip structures comprises: forming a plurality of grooves in the integrated electrical chip, forming a filling layer in each of the plurality of grooves, dicing the integrated electrical chip and the filling layer to obtain the plurality of electrical chip units, and forming the reflective portion on at least one sidewall of one the plurality of electrical chip units, and wherein a post dice sidewall of the filling layer with a reflective potion serves as the reflective surface.

5. The method according to claim 1, wherein forming the plurality of reflective chip structures comprises: dicing the integrated electrical chip to obtain the plurality of electrical chip units, forming a bonding layer on an upper surface of each of the plurality of the electrical chip units, and adhering the reflective portion above said electrical chip unit, and wherein a sidewall of the reflective portion serves as the reflective surface.

6. The method according to claim 1, wherein the reflective portion of each of the plurality of reflective chip structures is formed by sputtering, coating, or molding.

7. The method according to claim 1, wherein the reflective portion of each of the plurality of reflective chip structures comprises a highly reflective metal layer and a composite layer.

8. The method according to claim 1, wherein the semiconductor edge-emitting laser comprises a laser diode and a semiconductor laser chip.

9. The method according to claim 1, wherein the substrate is provided with a plurality of pads, wherein each of the plurality of reflective chip structures is electrically connected to the substrate through one of the plurality of pads, and the semiconductor edge-emitting laser is electrically connected to the substrate through of the plurality of pads.

10. The method according to claim 1, wherein after the semiconductor edge-emitting laser is electrically connected to the substrate and before the protective housing is formed, the method further comprises forming an underfill below the semiconductor edge-emitting laser and each one of the plurality of reflective chip structures.

11. The method according to claim 1, wherein the protective housing is provided with a protruding portion, and the light-transmissive component is disposed above the protective housing via the protruding portion.

12. An optoelectronic package structure, wherein the optoelectronic package structure is manufactured by the method according to any one of claims 1 to 11.
